# EUROPÄISCHE PATENTANMELDUNG

(11) **EP 0 945 524 A1**
(43) Veröffentlichungstag der Anmeldung: **29.09.1999**
(21) Anmeldenummer: 99102594.1
(22) Anmeldetag: 11.02.1999
(51) Int. Cl.: C23C 14/35, H01J 37/34

(54) **Vorrichtung zum Beschichten eines Substrates**

(30) Priorität: 25.03.1998 DE 19813075
(71) Anmelder: Balzers und Leybold Deutschland Holding AG, 63450 Hanau (DE)
(72) Erfinder: Teschner, Götz, 01307 Dresden (DE); Bräuer, Günter, 63579 Freigericht (DE); Faber, Ralf, 67251 Freinsheim (DE); Beisswenger, Siegfried Dr., 24211 Preetz (DE); Zöller, Alfons, 63628 Bad Soden Salmünster (DE)
(74) Vertreter: Schlagwein, Udo, Dipl.-Ing.

(57) **Zusammenfassung**

Eine Vorrichtung zum Beschichten eines Substrates (4) durch Kathodenzerstäubung hat in einem Rezipienten (1) eine innere, nach dem Magnetronprinzip arbeitende, erste Zerstäuberkathode (5) mit einem ersten Target (7) und eine ebenfalls nach dem Magnetronprinzip arbeitende, ringförmige, peripher zur ersten Zerstäuberkathode (5) angeordnete, zweite Zerstäuberkathode (6) mit einem kreisringförmigen, zweiten Target (8). Die erste Zerstäuberkathode (5) ist mit einer Verstellvorrichtung (12) zum Verstellen des axialen Abstandes zwischen den beiden Zerstäuberkathoden (5, 6) und damit des Abstandes zu dem Substrat (4) hin versehen.

## Beschreibung

Die Erfindung betrifft eine Vorrichtung zum Beschichten eines Substrates durch Kathodenzerstäubung, welche in einem Rezipienten eine innere, nach dem Magnetronprinzip arbeitende, erste Zerstäuberkathode mit einem ersten Target und eine ebenfalls nach dem Magnetronprinzip arbeitende, ringförmige, peripher zur ersten Zerstäuberkathode angeordnete, zweite Zerstäuberkathode mit einem kreisringförmigen, zweiten Target hat und bei der durch einen axialen Versatz der Zerstäuberkathoden die Targets in verschiedenen Ebenen angeordnet sind.

Eine Vorrichtung der vorstehenden Art ist Gegenstand der US 4,606,806. Bei der in dieser Schrift erläuterten Vorrichtung ist das zweite Target, welches peripher zum ersten Target angeordnet ist konisch ausgebildet und zur Ebene des ersten Targets höhenversetzt. Durch die besondere Gestaltung der Vorrichtung sollen sich hohe Sputterraten ergeben und mit einer großen Targetoberfläche ein ebenfalls großflächiges Substrat mit einer gleichmäßig dicken Beschichtung versehen lassen.

Da ringförmige Targets mit dreieckigem Querschnitt relativ teuer herzustellen sind, bevorzugt man in der Praxis bei Anlagen mit hoher Sputterrate solche, in denen als Targets planparallele Ringe benutzt werden können und ordnet diese koaxial zueinander in einer Ebene an. Als Beispiel für einen solchen Stand der Technik sei auf die DE 44 19 167 A1 verwiesen.

Wenn man bei der Kathodenzerstäubung eine hohe Sputterrate erreichen will, dann muss man den Abstand zwischen dem Target und dem Substrat relativ gering halten. Wird ein Abstand von etwa 5 bis 6 cm unterschritten, dann nimmt die Sputterrate in etwa proportional mit dem geringer werdenden Abstand des Substrates zu.

Will man gekrümmte Substrate mit hoher Sputterrate und deshalb geringem Substratabstand von der Zerstäuberkathode beschichten, beispielsweise Brillengläser, dann tritt wegen des erläuterten Zusammenhangs zwischen Abstand und Sputterrate das Problem auf, dass es zu einer in unterschiedlichen Bereichen unterschiedlich dicken Beschichtung kommt. Soll beispielsweise die konvexe Seite eines Brillenglases beschichtet werden, dann ist im mittleren Bereich des Brillenglases der Abstand zum Target geringer als außenseitig, so dass sich dort eine erhöhte Sputterrate und damit eine größere Schichtstärke ergibt. Das lässt sich zum Beispiel bei der Beschichtung von stark gekrümmten Brillengläsern mit SiO₂- oder TiO₂-Schichten auch durch eine stark asymmetrische Leistungseinkopplung nicht vermeiden. Es treten sogar Schichtrisse im Zentrum des Brillenglases durch Schichteigenspannungen auf. Deshalb verzichtet man in solchen Fällen auf den wirtschaftlichen Vorteil hoher Sputterraten und wählt einen solchen Abstand zwischen dem Target und dem Substrat, dass Abstandsunterschiede die Sputterrate nur noch gering beeinflussen.

Der Erfindung liegt das Problem zugrunde, eine Vorrichtung der eingangs genannten Art zu entwickeln, welche auch bei stark gekrümmten Substraten und geringem Abstand zum Target eine hohe und über die Fläche des Substrates möglichst gleichmäßige Sputterrate erlaubt.

Dieses Problem wird erfindungsgemäß gelöst durch eine Verstellvorrichtung zum Verstellen des axialen Abstandes zwischen den beiden Zerstäuberkathoden.

Eine solche Ausbildung erlaubt es beispielsweise beim Beschichten der konvexen Seite von Brillengläsern, die Zerstäuberkathoden so einzustellen, dass das erste, mittlere Target größeren Abstand vom Substrathalter hat als das zweite, ringförmige Target. Dadurch lässt sich für das erste Target in etwa ein gleicher Abstand von dem mittleren Bereich der ihm zugewandten, konvexen Oberfläche des Brillenglases erzielen wie für das zweite, ringförmige Target, so dass sich über die gesamte Fläche des Brillenglases eine weitgehend gleichmäßige Sputterrate und damit ebenfalls eine gleichmäßige Beschichtungsstärke ergibt. Die Verstellmittel ermöglichen eine leichte Anpassung an unterschiedlich gekrümmte Substrate, was beispielsweise bei Brillengläsern erforderlich ist, weil diese für die einzelnen Benutzer zur Korrektur des jeweiligen Augenfehlers unterschiedlich gekrümmt sind.

Konstruktiv besonders einfach ist die Vorrichtung gestaltet, wenn die erste Zerstäuberkathode mit der Verstellvorrichtung versehen ist.

Besonders kostengünstig sind die beiden benötigten Targets herzustellen, wenn sie aus einer einzigen Kreisscheibe durch Herausstechen eines inneren Bereiches als erstes, inneres Target gebildet sind.

Bei besonders großflächigen, konvex oder konkav gekrümmten Substraten oder bei besonders hohen Anforderungen an die Gleichmäßigkeit der Beschichtungsstärke kann man gemäß einer anderen Weiterbildung der Erfindung vorsehen, dass peripher und koaxial zu der zweiten Zerstäuberkathode eine dritte Zerstäuberkathode mit einem dritten, kreisringförmigen Target angeordnet und die erste Zerstäuberkathode und die dritte Zerstäuberkathode mit der Verstellvorrichtung versehen sind. Eine solche Anordnung von Zerstäuberkathoden erlaubt eine besonders genaue Anpassung an die Kontur eines gekrümmten Substrates.

Da es im mittleren Bereich eines kreisscheibenförmigen Targets ohnehin zu keiner Zerstäubung des Targetmaterials kommt, ist es bei größeren Targets vorteilhaft, wenn die erste Zerstäuberkathode ebenfalls ringförmig ausgebildet ist. Dadurch entsteht eine koaxiale Durchbrechung, die insbesondere für die Durchführung von Messgeräten genutzt werden kann.

Bei ganz besonders stark konvex gekrümmten, zu beschichtenden Substratflächen kann man erreichen, dass sich im äußeren Bereich ein schräg zu dem Substrat hin ausgerichtetes Plasma bildet, wenn gemäß einer anderen Weiterbildung der Erfindung die äußerste Zerstäuberkathode außenseitig an der äußeren Mantelfläche ihres Targets am substratseitigen Ende eine Magnetanordnung und auf ihrer dem Substrat abgewandten Ringfläche radial außen eine weitere Magnetanordnung aufweist.

Die Erfindung lässt verschiedene Ausführungsformen zu. Zur weiteren Verdeutlichung ihres Grundprinzips sind drei davon stark schematisch in der Zeichnung dargestellt und werden nachfolgend beschrieben. Diese zeigt in
- Fig.1: einen Schnitt durch eine erfindungsgemäße Beschichtungsanlage,
- Fig.2: einen Schnitt durch eine gegenüber Figur 1 abgewandelte Kathodenanordnung für eine Vorrichtung nach der Erfindung,
- Fig.3: einen Schnitt durch eine dritte Ausführungsform einer Kathodenanordnung.

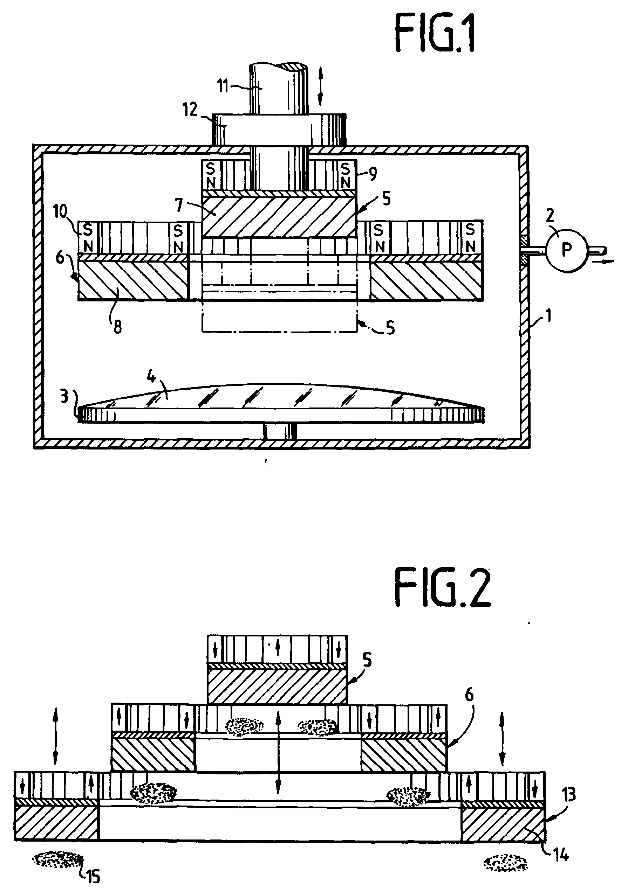

Die Figur 1 zeigt einen Rezipienten 1, welcher beim ArLeiten der Anlage mit einem Vakuumpumpstand 2 evakuiert wird. In dem Rezipienten 1 ist ein Substrathalter 3 angeordnet, auf welchem als Substrat 4 ein in Figur 1 gesehen nach oben hin konvex gekrümmtes Brillenglas aufliegt, dessen konvexe Seite zu beschichten ist.

Dem Substrat 4 gegenüber sind eine erste, kreisförmige Zerstäuberkathode 5 und eine zweite, ringförmige Zerstäuberkathode 6 angeordnet. Bei beiden Zerstäuberkathoden 5, 6 handelt es sich um Magnetronelektroden mit jeweils einem Target 7, 8 auf der dem Substrat 4 zugewandten Seite und jeweils einer Magnetanordnung 9, 10 auf der dem Substrat 4 abgewandten Seite. Die ringförmige Zerstäuberkathode 6 ist auf nicht gezeigte Weise innerhalb des Rezipienten 1 ortsfest montiert. Die innere Zerstäuberkathode 5 wird von einem aus dem Rezipienten 1 herausführenden Träger 11 gehalten und kann mittels einer Verstellvorrichtung 12 hinsichtlich ihres Abstandes zu der anderen Zerstäuberkathode 6 und damit zu dem Substrat 4 verstellt werden. Strichpunktiert dargestellt ist die Zerstäuberkathode 5 in ihrer untersten Stellung. Durch die Verstellbarkeit der Zerstäuberkathode 6 kann man erreichen, dass die Zerstäuberkathode 6 im mittleren Bereich des Substrates 4 die gleiche Sputterleistung hat wie die ringförmige Zerstäuberkathode 6, indem man im mittleren Bereich in etwa für einen gleichen Abstand vom Substrat 4 sorgt wie im äußeren Bereich. Bei dem dargestellten, konvexen Substrat 4 muss deshalb die mittlere Zerstäuberkathode 5, wie in durchgezogenen Linien dargestellt, höher angeordnet sein als die andere Zerstäuberkathode 6. Bei einer zu beschichtenden Fläche, welche konkav ist, muss man die mittlere Zerstäuberkathode 7, wie in strichpunktierten Linien dargestellt, nach unten in eine tiefere Stellung fahren. Die Verstellmöglichkeit erlaubt zusätzlich eine Anpassung an den jeweiligen Krümmungsradius eines Substrates.

Die Figur 2 zeigt eine Kathodenanordnung, bei der zusätzlich zu den Zerstäuberkathoden 5 und 6 eine dritte Zerstäuberkathode 13 mit einem Target 14 vorgesehen ist. In einem solchen Fall kann eine der in Figur 1 gezeigten Verstellvorrichtung 12 entsprechende Verstellvorrichtung jeweils für die innerste Zerstäuberkathoden 5 und für die äußere Zerstäuberkathode 14 vorgesehen sein, so dass nur die zweite Zerstäuberkathode 6 feststehend angeordnet ist. Eingezeichnet wurde in Figur 2 zugleich für die einzelnen Zerstäuberkathoden 5, 6 und 13 ein sich beim Arbeiten der Vorrichtung bildendes Plasma 15.

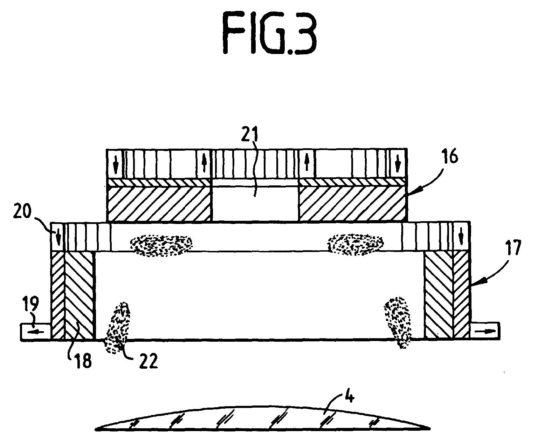

Bei der Ausführungsform nach Figur 3 ist eine innere Zerstäuberkathode 16 statt als geschlossener Körper genau wie die Zerstäuberkathode 6 gemäß den Ausführungsbeispielen nach den Figuren 1 und 2 als Ringkörper ausgebildet, so dass die Zerstäuberkathode 6 im mittleren Bereich eine Durchbrechung 21 hat, die zum Durchführen von Messgeräten genutzt werden kann. Eine ebenfalls ringförmige Zerstäuberkathode 17 mit einem Target 18 ist so gestaltet, dass eine Magnetanordnung 19 an der unteren Seite der äußeren Mantelfläche in radialer Ausrichtung und eine Magnetanordnung 20 außen an der oberen Stirnfläche in axialer Ausrichtung angebracht werden kann. Dadurch entsteht beim Arbeiten der Anlage ein schräg ausgerichtetes Plasma 22, was bei konvexen Substraten 4 zu einer Vergleichmäßigung der Schichtbildung führt.

### Bezugszeichenliste

- 1: Rezipient
- 2: Vakuumpumpstand
- 3: Substrathalter
- 4: Substrat
- 5: Zerstäuberkathode
- 6: Zerstäuberkathode
- 7: Target
- 8: Target
- 9: Magnetanordnung
- 10: Magnetanordnung
- 11: Träger
- 12: Verstellvorrichtung
- 13: Zerstäuberkathode
- 14: Target
- 15: Plasma
- 16: Zerstäuberkathode
- 17: Zerstäuberkathode
- 18: Target
- 19: Magnetanordnung
- 20: Magnetanordnung
- 21: Durchbrechung
- 22: Plasma

## Patentansprüche

1. Vorrichtung zum Beschichten eines Substrates durch Kathodenzerstäubung, welche in einem Rezipienten eine innere, nach dem Magnetronprinzip arbeitende, erste Zerstäuberkathode mit einem ersten Target und eine ebenfalls nach dem Magnetronprinzip arbeitende, ringförmige, peripher zur ersten Zerstäuberkathode angeordnete, zweite Zerstäuberkathode mit einem kreisringförmigen, zweiten Target hat und bei der durch einen axialen Versatz der Zerstäuberkathoden die Targets in verschiedenen Ebenen angeordnet sind, **gekennzeichnet durch** eine Verstellvorrichtung (12) zum Verstellen des axialen Abstandes zwischen den beiden Zerstäuberkathoden (5, 6).

2. Vorrichtung nach Anspruch 1, **dadurch gekennzeichnet,** dass die erste Zerstäuberkathode (5) mit der Verstellvorrichtung (12) versehen ist.

3. Vorrichtung nach den Ansprüchen 1 oder 2, **dadurch gekennzeichnet,** dass die beiden Targets (7, 8) aus einer einzigen Kreisscheibe durch Herausstechen eines inneren Bereiches als erstes, inneres Target (7) gebildet sind.

4. Vorrichtung nach zumindest einem der vorangehenden Ansprüche, **dadurch gekennzeichnet,** dass peripher und koaxial zu der zweiten Zerstäuberkathode (6) eine dritte Zerstäuberkathode (13) mit einem dritten, kreisringförmigen Target (14) angeordnet und die erste Zerstäuberkathode (5) und die dritte Zerstäuberkathode (13) mit der Verstellvorrichtung (12) versehen sind.

5. Vorrichtung nach zumindest einem der vorangehenden Ansprüche, **dadurch gekennzeichnet,** dass die erste Zerstäuberkathode (16) ebenfalls ringförmig ausgebildet ist.

6. Vorrichtung nach zumindest einem der vorangehenden Ansprüche, **dadurch gekennzeichnet,** dass die äußerste Zerstäuberkathode (17) außenseitig an der äußeren Mantelfläche ihres Targets (18) am substratseitigen Ende eine Magnetanordnung (19) und auf ihrer dem Substrat (4) abgewandten Ringfläche radial außen eine weitere Magnetanordnung (20) aufweist.
